# EUROPÄISCHE PATENTANMELDUNG

(11) **EP 2 490 515 A1**
(43) Veröffentlichungstag der Anmeldung: **22.08.2012**
(21) Anmeldenummer: 12167333.9
(22) Anmeldetag: 23.04.2009
(51) Int. Cl.: H05K 7/14, H05K 1/00, H01L 23/12, H01L 23/16, H01L 23/31, H01L 25/00, H05K 5/00, H01L 23/00, H01L 23/48, H01L 23/52, H01L 23/538

(54) **Elektrische Funktionseinheit und Verfahren zur Herstellung einer dreidimensionalen elektrischen Funktionseinheit**

(30) Priorität: 25.04.2008 DE 102008020930
(62) Teilanmeldung aus: 09100248.5
(71) Anmelder: Continental Automotive GmbH, 30165 Hannover (DE)
(72) Erfinder: Baur, Frank, 90482 Nürnberg (DE); Götte, Carsten, 93080 Pentling / Großberg (DE)

(57) **Zusammenfassung**

Eine Funktionseinheit, insbesondere geeignet zum Einbau in ein Fahrzeug, umfasst einen als Wanne ausgebildeten räumlichen Körper (1, 300) mit einem nichtleitenden Grundmaterial; wenigstens zwei an der Innenseite der Boden- (10c) und/oder zumindest einer der Seitenwände (10b) der Wanne (1, 300) angeordnete erste Leiterbahnen (12, 13), wenigstens zwei in der Wanne angeordnete Halbleiterkörper (20, 21), die jeweils eine integrierte Schaltung umfassen und von einem nichtleitenden Material (15) umschlossen sind und Kontaktstellen auf ihrer Oberfläche aufweisen, die mit den Leiterbahnen (12, 13) verbunden sind, wobei wenigstens eine Leiterbahn (12) Kontaktstellen der wenigstens zwei Halbleiterkörper (20, 21) miteinander verbindet, ein nichtleitendes Vergussmaterial (15), das zumindest die an der Bodenseite (10b) der Wanne (1; 300) angeordneten Halbleiterkörper (20, 21) bedeckt, wenigstens zwei auf dem Vergussmaterial (15) angeordnete zweite Leiterbahnen (14, 16, 34), von denen wenigstens eine elektrisch mit wenigstens einer der wenigstens zwei an der Innenseite der Boden- (10c) und/oder zumindest einer der Seitenwände (10b) der Wanne (1, 300) angeordneten ersten Leiterbahnen (12, 13) über Durchkontaktierungen (32, 33), die mit mit leitendem Material gefüllten Bohrungen (30, 31) gebildet sind, verbunden ist, wenigstens zwei weitere Halbleiterchips (24, 25), deren Kontaktpads mit Kontaktflächen der zweiten Leiterbahnen (14, 16, 34) verbunden sind, ein nichtleitendes Vergussmaterial, das die weiteren Halbleiterchips (24, 25) bedeckt.

## Beschreibung

Die Erfindung betrifft eine elektrische Funktionseinheit, insbesondere geeignet zum Einbau in ein Fahrzeug, umfassend einen als Wanne ausgebildeten räumlichen Körper mit einem nichtleitenden Grundmaterial; wenigstens zwei an der Innenseite der Boden- und/oder zumindest einer der Seitenwände der Wanne angeordnete erste Leiterbahnen, wenigstens zwei in der Wanne angeordnete Halbleiterkörper, die jeweils eine integrierte Schaltung umfassen und von einem nichtleitenden Material umschlossen sind und Kontaktstellen auf ihrer Oberfläche aufweisen, die mit den Leiterbahnen verbunden sind, wobei wenigstens eine Leiterbahn Kontaktstellen der wenigstens zwei Halbleiterkörper miteinander verbindet, ein nichtleitendes Vergussmaterial, das zumindest die an der Bodenseite der Wanne angeordneten Halbleiterkörper bedeckt.

Die Erfindung betrifft weiter ein Verfahren zur Herstellung einer solchen dreidimensionalen elektrischen Funktionseinheit.

Eine solche Funktionseinheit und ein solches Verfahren sind aus der EP 1 085 787 A1 und der US 5,179,601 bekannt.

Elektrische Funktionseinheiten sind Anordnungen, die in einem Betrieb spezifische elektrische Funktionen ausführen. Derartige elektrische Funktionseinheiten, beispielsweise in Kraftfahrzeugen, können Steuerungsgeräte sein, die in einem Gehäuse untergebracht sind, um sie gegen äußere Einflüsse zu schützen. Dabei üben die Steuerungsgeräte unterschiedliche Funktionen aus und besitzen verschiedene Anwendungsmöglichkeiten. Ein Beispiel für eine elektrische Funktionseinheit ist ein Sensor, der geschützt den Füllstand eines Tanks ermitteln soll. Ein weiteres Beispiel für eine elektrische Funktionseinheit ist das Steuergerät, welches nahe dem Motorblock vorgesehen sein kann.

Beispielsweise werden elektrische Funktionseinheiten als integrierter Schaltkreis in einem einzelnen Bauteil hergestellt. Dies schränkt jedoch die Flexibilität der Funktionseinheiten auf die jeweiligen Funktionen des integrierten Schaltkreises ein. Benötigt man entsprechend unterschiedliche oder weitere Funktionen, so ist es erforderlich, entweder einen eigenen integrierten Schaltkreis zu entwerfen und herzustellen bzw. standardisierte Baugruppen zusammenzufassen. Bei letzterem Fall werden oftmals Platinen verwendet, auf denen an einer Seite die einzelnen Chips für die unterschiedlichen Funktionen befestigt sind.

Dennoch besteht weiterhin das Bedürfnis, hochintegrierte elektrische Funktionseinheiten anzugeben, welche robust gegen äußere Einflüsse sind und eine hohe Flexibilität hinsichtlich verschiedener Anwendungsbereiche ermöglichen.

Diese Aufgabe wird mit den Gegenständen der unabhängigen Patentansprüche gelöst. Weiterbildende Maßnahmen und Ausgestaltungen der Erfindung sind Gegenstand der Unteransprüche.

Die Erfindung ist ausgehend von einer gattungsgemäße Funktionseinheit, gekennzeichnet durch wenigstens zwei auf dem Vergussmaterial angeordnete zweite Leiterbahnen, von denen wenigstens eine elektrisch mit wenigstens einer der wenigstens zwei an der Innenseite der Boden- und/oder zumindest einer der Seitenwände der Wanne angeordneten ersten Leiterbahnen über Durchkontaktierungen, die mit mit leitendem Material gefüllten Bohrungen gebildet sind, verbunden ist, wenigstens zwei weitere Halbleiterchips, deren Kontaktpads mit Kontaktflächen der zweiten Leiterbahnen verbunden sind, und ein nichtleitendes Vergussmaterial, das die weiteren Halbleiterchips bedeckt.

Es wird so eine elektrische Funktionseinheit in einem dreidimensionalen Aufbau geschaffen, indem eine mehrlagige Komponentenbestückung im Inneren eines räumlichen Körpers erfolgt. Die Komponenten können durch zusätzliche, in verschiedene Raumrichtungen verlaufende Leiterbahnen kontaktiert werden.

Die elektrische Funktionseinheit nach dem vorgeschlagenen Prinzip hat den Vorteil, dass standardisierte integrierte Schaltungen bzw. Chips zu einer hochintegrierten Funktionseinheit mit Mehrlagenaufbau kombiniert werden können. Dadurch wird eine Flexibilität hinsichtlich des gewünschten Anwendungsfalls erreicht, wobei die Funktionseinheit gleichzeitig zum Einbau in ein Fahrzeug oder ein anderes Fortbewegungsmittel geeignet ist. Zudem ist sie durch den vorhandenen räumlichen Körper, welcher den inneren Aufbau und insbesondere die Halbleiterkörper sowie die Leiterbahnen schützt, besonders robust gegenüber mechanischem Stress ausgeführt.

In einer Weiterbildung zeichnet sich die Erfindung durch zusätzliche Kontaktstellen aus, die auf einer äußeren Oberfläche des Körpers angeordnet sind und über Zuleitungen in dem Körper die integrierten Schaltungen der wenigstens zwei Halbleiterkörper kontaktieren. Auf diese Weise lassen sich die integrierten Schaltungen der Halbleiterkörper über externe Zuführungen und entsprechende Kontaktpads auf der Oberfläche des Körpers ansteuern und mit Strom versorgen.

Alternativ ist in einer Weiterbildung vorgesehen, dass eine der Leiterbahnen zu einer Leiterschleife zum Empfang oder Abgabe eines Transpondersignals ausgebildet ist. Dies erlaubt es, eine Funktionseinheit zu realisieren, die ohne äußere Kontakte ausgebildet ist. Energieversorgung und die Signalübertragung erfolgen drahtlos, beispielsweise über einen Transponder.

Eine derartige Funktionseinheit ist besonders zweckmäßig in Bereichen einzusetzen, in denen eine drahtgeführte Versorgung nicht möglich ist oder vermieden werden sollte. Ein Beispiel hierfür ist der Einsatz einer derartigen Funktionseinheit in einem Benzin- bzw. Öltank, bei der die Funktionseinheit über die Leiterschleife und ein entsprechendes Transpondersignal mit der für den Betrieb notwendigen Energie versorgt wird.

In einer Weiterbildung zeichnet sich die Erfindung dadurch aus, dass eine kleinste Ausdehnung des Körpers in eine Raumrichtung sowie eine größte Ausdehnung des Körpers in eine andere Raumrichtung ein Verhältnis von > 1:20 und insbesondere ein Verhältnis von > 1:10 zueinander aufweisen. Damit ist der Körper im Wesentlich rechteckförmig bzw. quadratisch aufgebaut, wodurch bei einer geeigneten Anordnung der Halbleiterkörper innerhalb des räumlichen Körpers eine hochintegrierte Funktionseinheit geschaffen werden. Die rechteckförmige Struktur erhöht zudem die Stabilität im Gegensatz zu den eher flächig aufgebauten Platinenformen.

In einer anderen Ausgestaltung zeichnet sich die Funktionseinheit dadurch aus, dass die Halbleiterkörper entlang unterschiedlicher Ausbreitungsrichtungen des Körpers angeordnet sind. Ebenso können die Leiterbahnen abschnittsweise entlang verschiedener Ausbreitungsrichtungen des Körpers verlaufen. Dadurch werden dreidimensionale Aufbauten der Halbleiterkörper innerhalb des Körpers sowie der die Halbleiterkörper verbindenden Leiterbahnen realisierbar. Insgesamt lässt sich so die Integrationsdichte der Funktionseinheit weiter erhöhen. Sofern im Betrieb eine größere Wärmemenge anfällt, zeichnet sich die Erfindung in einer Ausgestaltung durch zusätzliche Wärmeabführmittel aus, welche in einem Betrieb der integrierten Schaltung eine von der integrierten Schaltung erzeugte Wärme nach außen transportieren. Hierzu können die Leiterbahnen als Wärmeabführmittel dienen.

Je nach gewünschtem Anwendungsbereich können geeignete Materialien mit den entsprechenden Eigenschaften, beispielsweise Farbe, Wärmeleitfähigkeit, Ausdehnungskoeffizient oder thermischer Widerstand, ausgewählt werden.

Das Verfahren zur Herstellung einer dreidimensionalen Funktionseinheit zeichnet sich dadurch aus, dass eine Wanne bereitgestellt wird. Entlang einer Innenwandung der Wanne wird eine Metallisierung zur Bildung wenigstens einer Leiterbahn aufgebracht. Des Weiteren wird wenigstens ein Halbleiterkörper mit einer darin ausgebildeten integrierten Schaltung in der Wanne angeordnet und elektrisch mit der wenigstens einen Leiterbahn über einen auf dem Halbleiterkörper angeordneten Kontakt elektrisch gekoppelt. Schließlich wird die Wanne mit einem nicht leitenden Material aufgefüllt, so dass zumindest die an der Bodenseite der Wanne angeordneten Halbleiterkörper bedeckt sind. Anschließend werden Bohrungen in das Vergussmaterial eingebracht und mit leitendem Material zur elektrischen Kontaktierung der ersten Leiterbahnen gefüllt. Es wird eine Metallisierung zur Bildung von wenigstens zwei auf dem Vergussmaterial angeordneten zweiten Leiterbahnen aufgebracht, die elektrisch mit den ersten Leiterbahnen über die mit den mit leitendem Material gefüllten Bohrungen gebildeten Durchkontaktierungen verbunden sind. Anordnen Wenigstens zwei weitere Halbleiterchips werden auf den zweiten Leiterbahnen angeordnet und derer Kontaktpads mit Kontaktflächen der zweiten Leiterbahnen verbunden. Abschließend wird die Wanne mit einem nichtleitenden Vergussmaterial aufgefüllt, so dass zumindest die weiteren Halbleiterchips bedeckt sind.

Das Verfahren erlaubt es, eine vollständig hoch integrierte elektrische Funktionseinheit dreidimensional und robust gegen äußere Einflüsse herzustellen. Dabei können insbesondere bereits standardisierte integrierte Schaltungen in der Funktionseinheit verbaut werden, ohne neuartige Designs und integrierte Schaltungen herstellen zu müssen.

In erfindungsgemäßer Weise wird die Wanne in einzelnen Arbeitsschritten mit verschiedenen Halbleiterkörpern bestückt und diese über das nicht leitende Material fixiert. Zusätzlich können entsprechende Metallisierungsebenen als Leiterbahnen auf dem nicht leitenden Material abschnittsweise strukturiert werden, um die integrierten Schaltungen der aufgebrachten Halbleiterkörper zu kontaktieren.

In einer Weiterbildung zeichnet sich das Verfahren durch ein Pressen der Leiterbahnen in wenigstens eine Innenwand der Wanne aus. Alternativ wird die Innenwand teilweise ausgehöhlt und anschließend die Metallisierung in die Vertiefung eingebracht. Somit lassen sich Leiterbahnen entlang der Innenwände der Wanne verlegen. In diesem Zusammenhang ist es möglich, Halbleiterkörper in der Wanne bezüglich ihrer Hauptfläche entlang unterschiedlicher Raumrichtungen in der Wanne anzuordnen. Beispielsweise können auf diese Weise Halbleiterkörper an den verschiedenen Seitenwänden mit den in den Seitenwänden eingebrachten Leiterbahnen verbunden werden.

Im Folgenden wird die Erfindung anhand von Ausführungsbeispielen unter Zuhilfenahme von Zeichnungen im Detail erläutert. Es zeigen:
- Figur 1A bis Figur 1I: schematische Querschnittsansichten einer Wanne zur Darstellung einer Ausführungsform des Herstellungsverfahrens nach dem vorgeschlagenen Prinzip,
- Figur 2A, 2B: schematische Querschnittsansichten zur Darstellung einer weiteren Ausführungsform des Verfahrens,
- Figur 3: eine perspektivische Ansicht eines Körpers mit darin eingebrachten Leiterbahnen und Halbleiterkörpern.

Die im Folgenden dargestellten Elemente sind nicht maßstabsgerecht gezeichnet. Vielmehr sind einzelne Bauteile bzw. Elemente zum Zwecke verbesserter Übersichtlichkeit vergrößert bzw. verkleinert dargestellt. Wirkungs- bzw. funktionsgleiche Bauelemente tragen die gleichen Bezugszeichen. Der Begriff räumlicher Körper bezeichnet im Folgenden eine dreidimensionale kompakte Struktur, bei denen jede der Seitenwände in die drei Raumrichtung signifikante Abmessungen bezogen der Abmessungen der jeweils anderen Seitenwände haben. Während also eine Platine eine Dicke aufweist, die im Gegensatz zur Länge oder Breite deutlich geringer ist, liegen die Ausdehnungen in alle drei Raumrichtungen bei einem räumlichen Körper in der gleichen Größenordnung. Beispielsweise weichen die Ausdehnungen in alle drei Raumrichtungen lediglich um den Faktor 20 oder weniger, beispielsweise 10, 5 oder 2 voneinander ab. Ein solcher räumlicher Körper ist ein Quader oder auch ein Würfel.

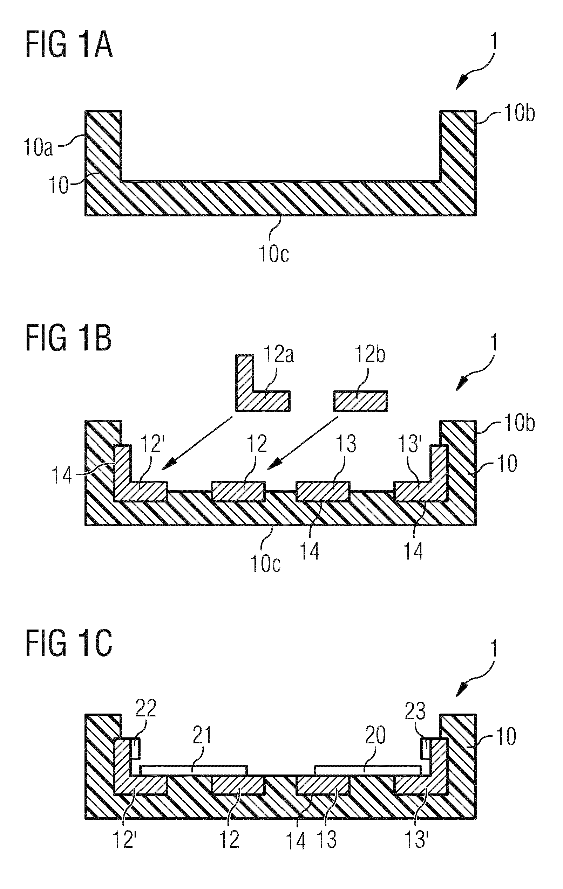

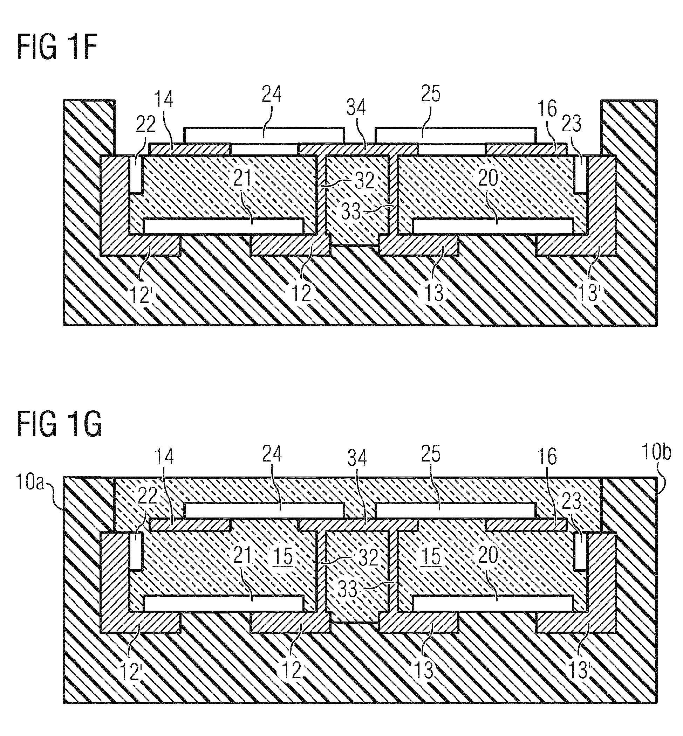

Figur 1A zeigt einen Querschnitt eines Grundkörpers, beispielsweise einer Wanne, mit Seitenwänden 10a und 10b sowie einem Boden 10c. Im vorliegenden Ausführungsbeispiel sind die Seitenwände im Wesentlichen senkrecht zum Boden 10c angeordnet. Die Länge des Bodens 10c ist im Wesentlichen um den Faktor 3 größer als die entsprechende Höhe der Seitenwände 10b. Diesbezüglich sind jedoch auch andere Maße möglich, sodass insgesamt ein dreidimensionaler Körper gebildet wird. Somit ist der Körper nicht hauptsächlich flächig, sondern räumlich ausgebildet. Dabei soll die Länge seiner kleinsten Ausdehnung im Verhältnis zur Länge seiner größten Ausdehnung keine kleineren Werte als 1:20 bzw. 1:10 aufweisen. Im vorliegenden Ausführungsbeispiel ist das Verhältnis der Länge der Seitenwände 10a zum Boden 10c ca. 1:3.

Im ersten Verfahrensschritt gemäß Figur 1A wird der Grundkörper beispielsweise gemouldet. Je nach späterer Verwendung dienen als Material Kunststoffe verschiedener Art, aber auch Keramiken oder andere nicht leitende Materialien.

In den nächsten Verfahrensschritten gemäß Figur 1B wird eine Metallisierung in die Wanne eingebracht, sodass verschiedene Leiterebenen 12 und 13 gebildet werden. Eine Möglichkeit hierzu besteht in einer so genannten Laseraktivierung, bei der ein Teilbereich 14 der Bodenwand 10c sowie ein Teilbereich 14 der Seitenwand 10b entfernt wird. Mit anderen Worten wird der Boden 10c sowie die Seitenwand 10b im Bereich der späteren Metallisierung strukturiert. Dies kann beispielsweise über eine Laserbestrahlung erfolgen, mit deren Hilfe eine entsprechende Vertiefung 14 in die Seitenwand bzw. Bodenwand der Wanne eingebrannt wird. Anschließend wird eine Metallisierung in die Vertiefung eingesetzt, sodass sich die Leiterbahn 13 bildet. Im vorliegenden Ausführungsbeispiel ist die Metallisierung geringfügig dicker als die vorhandene Vertiefung 14, sodass sie über die Innenoberfläche der Wanne leicht hinausragt.

Eine alternative Möglichkeit zur Erzeugung entsprechender Leiterbahnen in der Innenwand der Wanne besteht darin, die entsprechenden Leiterbahnen 12a und 12b in die Innenwand der Wanne zu pressen. Dabei wird die Wanne an der Stelle geringfügig erwärmt, sodass durch ein späteres Einpressen der Leiterbahnen 12a, 12b eine Verbindung hergestellt und ein Ablösen der Leiterbahn vermieden wird. Eine Erwärmung kann bei einem thermoplastischen Material beispielsweise über Licht oder Lasereinstrahlung erfolgen. Des Weiteren kann die Leiterbahn auch mit der Innenwand der Wanne über einen Klebstoff verbunden werden.

Gemäß Figur 1C werden nun verschiedene Halbleiterkörper 20 bis 23 mit den in den vorangegangenen Schritten prozessierten Leiterbahnen verbunden. Zu diesem Zweck wird der zwischen den Leiterbahnen 12 und 13 vorhandene Zwischenraum mit einem Kunststoff aufgefüllt und auf diesen die Halbleiterkörper 20 und 21 gesetzt. Beide Halbleiterkörper enthalten integrierte Schaltungen sowie Kontaktpads auf der Unterseite, die die entsprechenden Leiterbahnen 12 bzw. 13 kontaktieren. In gleicher Weise werden auch auf den Seitenwänden 10b bzw. 10a weitere Halbleiterkörper 22 und 23 angeordnet und mit den auf den Seitenwänden befindlichen Leiterbahnen verbunden. Somit kontaktieren die Leiterbahn 12' die Kontaktpads der Halbleiterchips 21 und 22 und die Leiterbahn 13' die Kontaktpads der Chips 20 und 23.

In diesem Schritt werden so erste Lagen verschiedener Halbleiterkörper und integrierter Schaltungen innerhalb der Wanne durch die entsprechende Anordnung entlang der Seitenwände miteinander verbunden, um unterschiedliche Funktionalität zu erreichen.

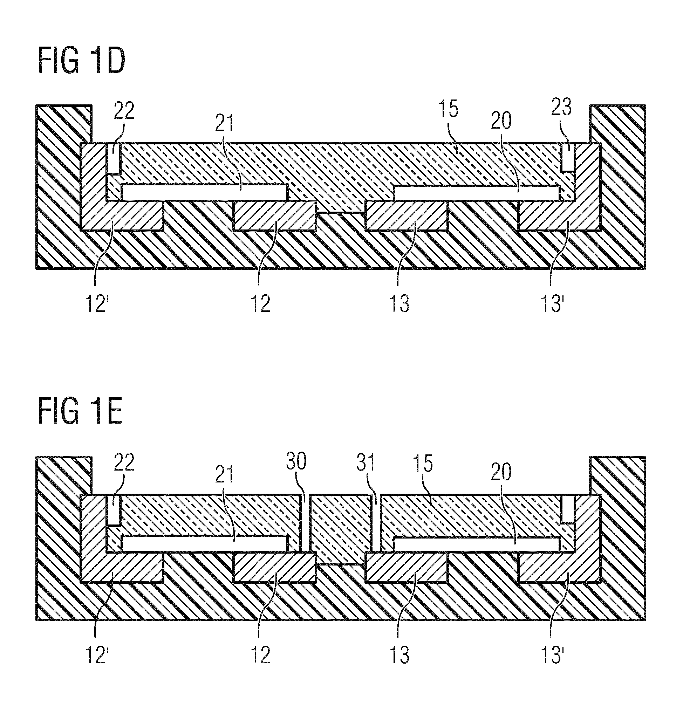

Gemäß Figur 1D werden nun die vorhandenen Zwischenräume mit einem nicht leitenden Material aufgefüllt. Mit anderen Worten werden die Komponenten, die Halbleiterchips 20 bis 23, im darauf folgenden Prozessschritt vergossen. Dies erfolgt anteilsweise und daher nicht vollständig, um eine nächste Prozessebene zu definieren. Als Vergussmaterial können unterschiedliche Kunststoffe eingesetzt werden.

Anschließend werden gemäß Figur 1E mehrere Bohrungen 30 und 31 für Durchkontaktierungen in das vorher eingefüllte Vergussmaterial (15) eingebracht. Dies kann beispielsweise mechanisch, aber auch über einen Laser oder durch einen Ätzprozess erreicht werden. Die Bohrung 30, 31 legt dabei einen Teil der Leitungsebene 12 bzw. 13 frei.

Sodann wird ein leitendes Material in die vorhandene Bohrung gefüllt, um die darunter liegenden Leiterbahnen 12 und 13 der ersten Ebene zu kontaktieren. Auf der Oberfläche des Vergussmaterials 15 werden nun weitere Leitungsebenen 14, 16 und 34 definiert und diese ggf. mit den Durchkontaktierungen 32, 33. Sodann werden auf die entsprechenden Kontaktflächen dieser Leiterbahnebenen 14, 16 und 34 weitere Chips 24 und 25 aufgebracht und deren Kontaktpads mit den Kontakten der Leiterbahnen 14, 16 und 34 verbunden.

In einem weiteren Verfahrensschritt gemäß Figur 1G werden die vorhandenen Zwischenräume und die restliche Wanne mit einem Vergussmaterial bis zur Oberfläche der Seitenwände 10a und 10b aufgefüllt.

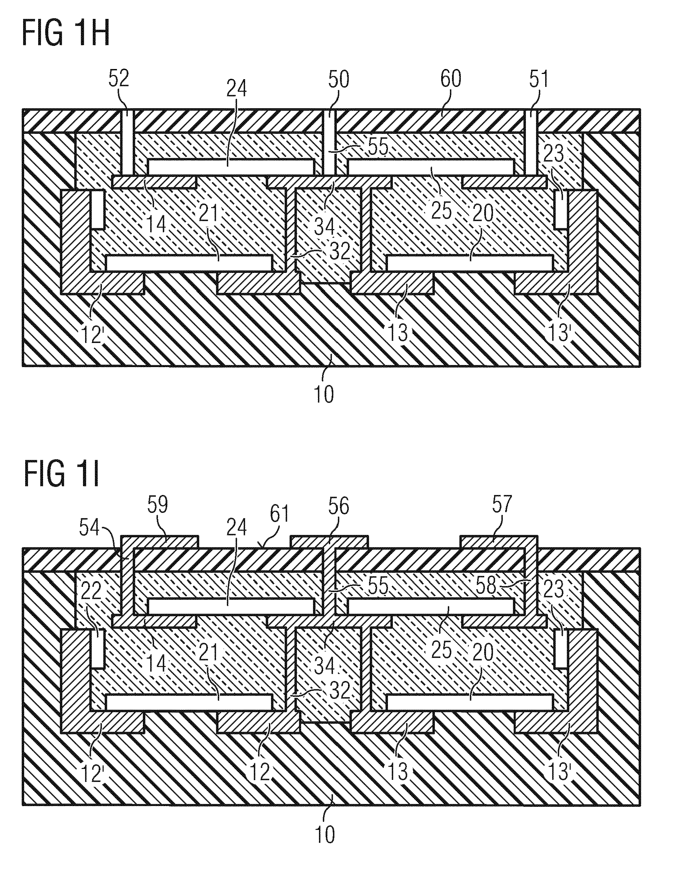

Gemäß Figur 1H wird die Wanne nun mit einer Deckschicht 60 aus dem gleichen Material wie die Seitenwände 10a und 10b sowie die Bodenwand 10c abgeschlossen, sodass der dreidimensionale Körper gebildet wird. Auf der Oberseite 60 werden anschließend über Bohrungen 50, 51 und 52 Löcher in den Körper durch die Deckschicht 60 und das Vergussmaterial 15 bis hin zu der zweiten Leitungsebene mit den Leiterbahnen 14, 16 und 34 eingebohrt. Dies kann wiederum durch Bohren, Ätzen oder über einen Laser mittels thermischer Zerstörung erfolgen.

Gemäß Figur 1I werden die Bohrungen anschließend mit einem Material 54, 55 und 58 aufgefüllt und auf der Oberfläche 61 der Deckschicht 60 Kontaktpads 56, 57 und 59 zur Kontaktierung der einzelnen Zuleitungen und Chips 20, 21, 24 und 25 vorgesehen.

Somit wird eine elektrische Funktionseinheit geschaffen, die aufgrund ihrer kompakten räumlichen Ausdehnung mechanisch besonders robust ist und gleichzeitig über die vorhandenen Kontaktpads auf der Oberfläche einen Anschluss zu den innerhalb der Wanne befindlichen integrierten Schaltungen erlaubt.

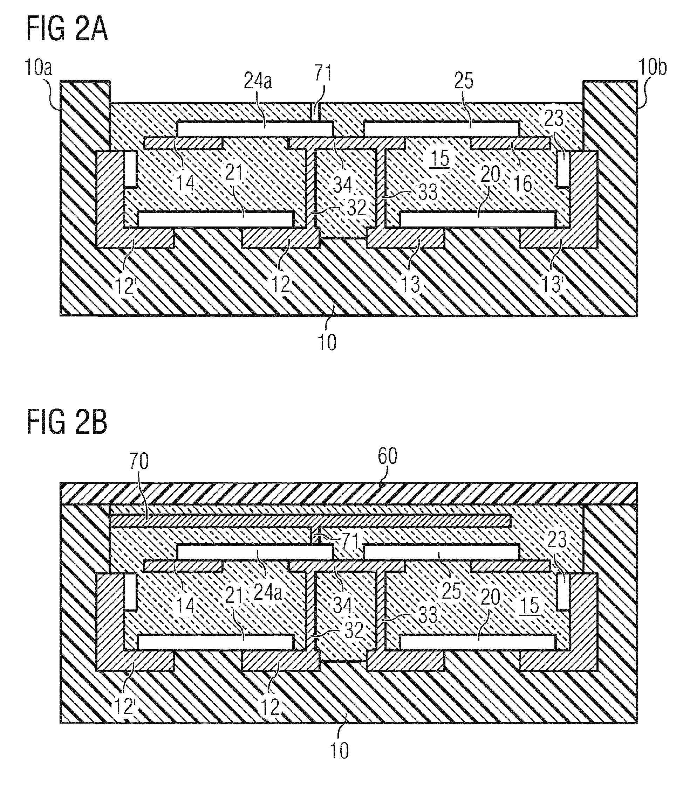

Eine alternative Ausgestaltung einer elektrischen Funktionseinheit, einschließlich des Herstellungsverfahrens, ist in den Figuren 2A und 2B dargestellt. Bei der dargestellten elektrischen Funktionseinheit erfolgt die Stromversorgung als auch die Signalaufnahme oder -abgabe drahtlos. Zu diesem Zweck ist der Chip 24a als Transponderchip ausgeführt und mit den Leitungsebenen 34 und 14 innerhalb der Wanne verbunden. Der Transponderchip 24a und der zweite Chip 25 sind wieder von dem Vergussmaterial 15 umschlossen, welches nicht bis an die Oberseite der Seitenwände 10a und 10b der Wanne reicht. In das Vergussmaterial 15 wird eine Bohrung 71 eingebracht, die das Transponderkontaktpad des Transponderchips 24a freilegt. Anschließend wird gemäß Figur 2B ein Material 71 in die vorhandene Öffnung eingefüllt, um das Kontaktpad des Transponderchips 24a zu kontaktieren.

Des Weiteren wird kurz unterhalb der Oberfläche eine Leiterschleife 70 auf dem Vergussmaterial 15 strukturiert. Diese Leiterschleife dient im Betrieb der Anordnung einerseits zur Übertragung der für den Betrieb erforderlichen Energie und gleichzeitig zum Empfang und zur Abgabe der notwendigen Transpondersignale. Die Wanne wird nun bis an den Rand der Seitenwände mit dem Vergussmaterial 15 aufgefüllt und anschließend in die Deckschicht 60 aufgebracht. Damit verschließt die Deckschicht 60 hermetisch den Innenbereich der Wanne, sodass ein mit einem Material den Chips und den Leiterbahnen enthaltener Hohlkörper entsteht.

Die elektrische Funktionseinheit nach dem vorgeschlagenen Prinzip kann aufgrund der drahtlosen Stromversorgung und der drahtlosen Signalübertragung besonders in Bereichen eines Kraftfahrzeugs eingesetzt werden, bei denen eine drahtgebundene Stromversorgung unmöglich oder unzweckmäßig erscheint. Beispielsweise kann die Funktionseinheit nach dem vorgeschlagenen Prinzip als Füllstandsensor in einem Öl- oder Benzintank verwendet werden. Ebenso sind Luftdrucksensoren im Bereich der Reifen möglich, da die gebildete Funktionseinheit gegenüber mechanischen Belastungen besonders stabil ist.

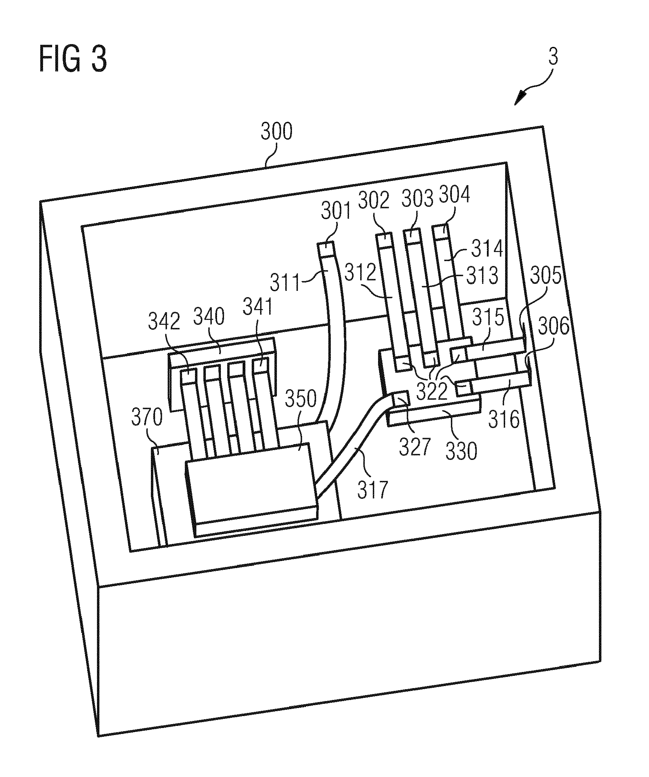

Figur 3 zeigt eine perspektivische Ansicht einer elektrischen Funktionseinheit 3. Die elektronische Funktionseinheit 3 umfasst einen im Wesentlichen quaderförmigen Körper 300 in Form einer Schachtel mit Seitenwänden, die im Wesentlichen zueinander senkrecht angeordnet sind. Der Innenbereich des Körpers 300 ist mit einem transparenten Vergussmaterial versehen, um die darin befindlichen Elemente kenntlich zu machen.

Auf verschiedenen Ebenen innerhalb des Körpers 300 sind einzelne Chips 330, 350 und 340 angeordnet. Im Einzelnen sind ein erster Chip 330 auf dem Boden des Körpers 300, ein zweiter Chip 350 auf einem aus nicht transparentem Kunststoff bestehenden Sockel 370 und ein weiterer Chip 340 entlang einer Seitenwand des Körpers 300 angeordnet. Der Chip 340 steht somit mit seiner Hauptfläche senkrecht zu den Hauptflächen der Chips 350 bzw. 330 und parallel zu einer Seitenwand des Körpers 300.

In den Seitenwänden des Körpers 300 sind verschiedene Öffnungen 301 bis 304, 305 und 306 eingebracht. Diese führen zu nicht dargestellten Kontaktpads auf der Außenseite der Wände des Körpers 300 und sind innerhalb des Körpers 300 über Leitungsbahnen 311 bis 316 mit entsprechenden Kontaktpads auf der Oberseite der Halbleiterchips 330 bzw. 350 verbunden.

Im Einzelnen sind die Öffnungen 302 und 303 sowie 305 und 306 über Leitungsebenen 312, 313, 315 und 316 an Kontaktpads 322 auf der Oberseite des Chips 330 geführt. Die Leiterbahn 314 kontaktiert die Bohrung 304 in der Seitenwand des Körpers 300 und führt entlang der Seitenwände und des Bodens des Körpers 300 zu einem Kontaktpad auf der Unterseite des Chips 330. Demzufolge sind die Leiterbahnen 312, 313, 315 und 316 in einer Ebene, die Leiterbahn 314 in einer zweiten Ebene angeordnet.

Die Leiterbahn 311 kontaktiert die Bohrung 301 in der Seitenwand des Körpers 300 und führt zu einem Kontaktpad auf der Unterseite des Chips 350. Ebenso ist ein Kontaktpad 327 des Chips 330 über eine parallel zum Boden der Wanne verlaufenden Leiterbahn 317 mit einem Kontaktpad auf der Unterseite des Chips 350 verbunden. Die Leiterbahnen zur Kontaktierung des Chips 350 und der Sockel 370 sind gut wärmeleitend, so dass sie eine im Betrieb der integrierten Schaltung des Chip 350 erzeugte Wärme nach außen leiten.

Der Chip 340 ist gegenüber den beiden Halbleiterchips 350 und 330 senkrecht angeordnet. Auf seiner Vorderseite besitzt er eine Vielzahl von Anschlusskontakten 341 und 342, die über Leiterbahnen in einer Ebene mit den Kontakten auf der Unterseite des Chips 350 verbunden sind.

Die Funktionseinheit umfasst somit eine Vielzahl von Halbleiterchips, die über Leiterbahnen in verschiedenen Ebenen innerhalb eines Körpers 300 miteinander verbunden sind. Durch das verwendete durchsichtige Kunststoffmaterial kann eine Lithographie mit Hilfe eines Belichtungsvorgangs des dreidimensionalen Körpers besonders einfach durchgeführt werden. Dies erfolgt, indem die einzelnen Schichten von außen belichtet und dadurch strukturiert werden können. Als Kunststoffe für den Körper 300 als auch als Vergussmaterial können Thermoplaste, aber auch Epoxydharze und andere mechanisch stabile und/oder chemisch inerte Materialien verwendet werden.

Durch die Verwendung von chemisch inertem Kunststoff als Grundmaterial für den räumlichen Körper ist die Funktionseinheit auch in besonderen Umgebungen, beispielsweise in einer Ölwanne, in einem Tank oder Ähnlichem, einsetzbar.

Die Funktionseinheit hat auch den Vorteil, dass durch die vorgeschlagene Bauweise Halbleiterchips verwendet werden können, die Kontakte auf unterschiedlichen Seiten haben können. Daher ist eine räumliche Integration verschiedenster funktionaler Baugruppen und integrierter Schaltungen in verschiedene Raumrichtungen möglich.

## Patentansprüche

1. Funktionseinheit, insbesondere geeignet zum Einbau in ein Fahrzeug, umfassend:
- einen als Wanne ausgebildeten räumlichen Körper (1, 300) mit einem nichtleitenden Grundmaterial;
- wenigstens zwei an der Innenseite der Boden- (10c) und/oder zumindest einer der Seitenwände (10b) der Wanne (1, 300) angeordnete erste Leiterbahnen (12, 13),
- wenigstens zwei in der Wanne angeordnete Halbleiterkörper (20, 21), die jeweils eine integrierte Schaltung umfassen und von einem nichtleitenden Material (15) umschlossen sind und Kontaktstellen auf ihrer Oberfläche aufweisen, die mit den Leiterbahnen (12, 13) verbunden sind, wobei wenigstens eine Leiterbahn (12) Kontaktstellen der wenigstens zwei Halbleiterkörper (20, 21) miteinander verbindet,
- ein nichtleitendes Vergussmaterial (15), das zumindest die an der Bodenseite (10b) der Wanne (1; 300) angeordneten Halbleiterkörper (20, 21) bedeckt,
**gekennzeichnet durch**
- wenigstens zwei auf dem Vergussmaterial (15) angeordnete zweite Leiterbahnen (14, 16, 34), von denen wenigstens eine elektrisch mit wenigstens einer der wenigstens zwei an der Innenseite der Boden- (10c) und/oder zumindest einer der Seitenwände (10b) der Wanne (1, 300) angeordneten ersten Leiterbahnen (12, 13) über Durchkontaktierungen (32, 33), die mit mit leitendem Material gefüllten Bohrungen (30, 31) gebildet sind, verbunden ist,
- wenigstens zwei weitere Halbleiterchips (24, 25), deren Kontaktpads mit Kontaktflächen der zweiten Leiterbahnen (14, 16, 34) verbunden sind,
- ein nichtleitendes Vergussmaterial, das die weiteren Halbleiterchips (24, 25) bedeckt.

2. Funktionseinheit nach Anspruch 1, wobei auf einer äußeren Oberfläche (61) einer Deckschicht (60) des Körpers (1) wenigstens zwei Kontaktstellen (56, 57, 59) angeordnet sind, welche über Zuleitungen (54, 55, 58) in dem Körper (1, 300) die integrierten Schaltungen der wenigstens zwei Halbleiterkörper (20, 21, 22) kontaktieren.

3. Funktionseinheit nach Anspruch 1, wobei auf dem die weiteren Halbleiterchips (24, 25) bedeckenden Vergussmaterial eine Leiterschleife zum Empfang oder Abgabe eines Transpondersignals ausgebildet ist, die über Durchkontaktierungen (71) mit einem Transponderchip (24a) elektrisch verbunden ist.

4. Funktionseinheit nach einem der Ansprüche 1 bis 3, wobei eine kleinste Ausdehnung des Körpers (1, 300) in eine Raumrichtung und eine größte Ausdehnung des Körpers (1, 300) in eine andere Raumrichtung ein Verhältnis von größer als 1:20, insbesondere ein Verhältnis von größer als 1:10 aufweisen.

5. Funktionseinheit nach einem der Ansprüche 1 bis 4, wobei ein erster der wenigstens zwei Halbleiterkörper (20) entlang einer ersten Ausbreitungsrichtung des Körpers (1) und ein zweiter der wenigstens zwei Halbleiterkörper (22) entlang einer zweiten Ausbreitungsrichtung des Körpers (1) angeordnet ist.

6. Funktionseinheit nach einem der Ansprüche 1 bis 5, wobei wenigsten eine der Leiterbahnen (12, 12') abschnittsweise entlang einer ersten Ausbreitungsrichtung des Körpers (1) und entlang einer zweiten Ausbreitungsrichtung des Körpers (1) verläuft.

7. Funktionseinheit nach einem der Ansprüche 1 bis 6, wobei der Körper (1) wenigstens ein Wärmeabführmittel (370) umfasst, welches in einem Betrieb der integrierten Schaltung von der integrierten Schaltung erzeugte Wärme nach außen transportiert.

8. Funktionseinheit nach einem der Ansprüche 1 bis 7, wobei das Grundmaterial und das die Halbleiterkörper umschließende Material aus dem gleichen Material, insbesondere einem Kunststoff gebildet sind.

9. Verfahren zur Herstellung einer dreidimensionalen Funktionseinheit, umfassend ein
- Bereitstellen einer Wanne (1, 300);
- Aufbringen einer Metallisierung zur Bildung von wenigstens zwei an der Innenseite der Boden- (10c) und/oder zumindest einer der Seitenwände (10b) der Wanne (1, 300) angeordneten ersten Leiterbahnen (12, 13),
- Anordnen von wenigstens zwei Halbleiterkörpern (20, 21), die jeweils eine integrierte Schaltung umfassen und von einem nichtleitenden Material (15) umschlossen sind und Kontaktstellen auf ihrer Oberfläche aufweisen, in der Wanne und elektrisches Koppeln der Halbleiterkörper (20, 21) mit den ersten Leiterbahnen (12, 13) über die Kontaktstellen,
- Auffüllen der Wanne (1; 300) mit einem nichtleitenden Vergussmaterial (15), so dass zumindest die an der Bodenseite (10b) der Wanne (1; 300) angeordneten Halbleiterkörper (20, 21) bedeckt sind,
- Einbringen von Bohrungen (30, 31) in das Vergussmaterial (15) und Füllen der Bohrungen (30, 31) mit leitendem Material zur elektrischen Kontaktierung der ersten Leiterbahnen (12, 13),
- Aufbringen einer Metallisierung zur Bildung von wenigstens zwei auf dem Vergussmaterial (15) angeordneten zweiten Leiterbahnen (14, 16, 34), die elektrisch mit den ersten Leiterbahnen (12, 13) über die mit den mit leitendem Material gefüllten Bohrungen (30, 31) gebildeten Durchkontaktierungen (32, 33) verbunden sind,
- Anordnen von wenigstens zwei weiteren Halbleiterchips (24, 25) auf den zweiten Leiterbahnen und Verbinden derer Kontaktpads mit Kontaktflächen der zweiten Leiterbahnen (14, 16, 34),
- Auffüllen der Wanne (1; 300) mit einem nichtleitenden Vergussmaterial, so dass zumindest die weiteren Halbleiterchips (20, 21) bedeckt sind.

10. Verfahren nach Anspruch 9, bei dem eine Leiterbahn (12, 13) in die Innenwand gepresst, oder die Innenwand teilweise ausgehöhlt und anschließend die Metallisierung in die Vertiefung eingebracht wird.
